# EUROPEAN PATENT SPECIFICATION

(11) **EP 2 312 626 B1**
(45) Date of publication and mention of the grant of the patent: **31.07.2013**
(21) Application number: 09011611.2
(22) Date of filing: 10.09.2009
(51) Int. Cl.: H01L 23/427, F28D 15/02, F28F 1/32

(54) **Heat pipe assembly**
Wärmerohreinheit
Ensemble de caloduc

(43) Date of publication of application: 20.04.2011
(73) Proprietor: CPUMATE INC., Taipei County 248 (TW); Golden Sun News Techniques Co., Ltd., Taipei County 248 (TW)
(72) Inventor: Lin, Kuo-Len, Wugu Township Taipei County 248 (TW); Lin, Chen-Hsiang, Wugu Township Taipei County 248 (TW); Hsu, Ken, Wugu Township Taipei County 248 (TW); Cheng, Chih-Hung, Wugu Township Taipei County 248 (TW)
(74) Representative: Ter Meer Steinmeister & Partner

(56) References cited:
- US-A1- 2006 266 500
- US-A1- 2007 144 710
- US-A1- 2008 216 990
- US-B1- 7 443 676

## Description

### BACKGROUND

The present invention relates to heat dissipation devices, and particularly to a heat pipe assembly including a number of heat pipes and a fixing structure which enables evaporating sections of the heat pipes being parallel to and adjoining with each other, and a heat dissipation device including such a heat pipe assembly.

With the development of computer technologies, electronic elements run at high speed and therefore generate large amounts of heat. In order to keep the electronic elements operating at a normal temperature, the heat must be quickly and efficiently removed from the electronic elements by a heat dissipation device. Conventionally, the heat dissipation device includes a heat pipe which uses a gas-liquid phase transition technology to dissipate the heat generated by the electronic elements.

However, in order to increase the heat dissipation efficiency of the heat dissipation device, a number of heat pipes are included in the heat dissipation device. Currently, the heat pipes are secured to a base seat or a heat conducting seat of the heat dissipation device by welding method. Also, evaporation sections of the heat pipes may be embedded in the grooves defined on the base seat or the heat conducting seat of the heat dissipation device and secured to the base seat or the heat conducting seat. However, the welding process is not easy to perform and the welded heat dissipation device has an unattractive appearance. When the evaporation sections of the heat pipes are embedded in the groves of the base seat or a heat conducting seat, the evaporation sections must be spaced from each other and can not be tightly adjoin with each other, whereby the evaporating sections can not be gathered to thermally contact with a surface of a heat generating electronic element. As a result, outermost two of the heat pipes can not be sufficiently used, thereby the heat dissipation device having low heat dissipation efficiency.

U.S. patent No. 7,443,676 discloses a heat sink composed of fins, a fixing seat and heat pipes. The U-shaped heat pipes penetrate the fixing seat to make their evaporating sections coplanar but separate.

U.S. patent application publication No. 2007/0144710 discloses a heat sink similar to '676.

U.S. patent application publication No. 2008/0216990 discloses another heat sink also composed of a fixing seat, heat pipes and fins. One end of the heat pipes adjoins with each other. However, the adjoined portions, the evaporating sections, are depressed oval in shape. Thus a gap will be formed between any two adjacent heat pipes. The gaps must be disadvantageous to heat transferring efficiency.

Therefore, what is needed is a heat pipe assembly, thereby overcoming the above-described problems.

### BRIEF SUMMARY

The present invention provides a heat pipe assembly as claimed in claim 1. The heat pipe assembly includes a number of evaporation sections and a molded fixing seat. By the fixing structure, the evaporating sections of the heat pipe assembly are parallel to and adjoin with each other, whereby heat absorb surfaces of the evaporating sections are coplanar and adjoin with each other to thereby form a large-area heat absorbing surface to thermally contact with a heat generating electronic element.

The heat pipe assembly includes a number of heat pipes and a fixing seat engaging with evaporating sections of the heat pipes. Each of the heat pipes includes an evaporating section and at least a condensing section. A bottom of the evaporation section of each of the heat pipes is flat and has a flat heat absorbing surface due to the rectangular cross-section. The evaporating sections of the heat pipes are parallel to and adjoin with each other, whereby the heat absorbing surfaces thereof are coplanar and adjoin with each other. A top surface of the evaporating section of each of the heat pipes has a top edge. The fixing seat has an integral structure and combines with the top edges of the evaporating sections of the heat pipes, thereby facilitating the heat absorbing surfaces of the evaporating sections of the heat pipes being coplanar and adjoining with each other.

### BRIEF DESCRIPTION OF THE DRAWINGS

These and other features and advantages of the various embodiments disclosed herein will be better understood with respect to the following description and drawings, in which like numbers refer to like parts throughout, and in which:

FIG. 1 is a schematic, isometric view of a heat pipe assembly, according to a first embodiment of the present disclosure.

FIG. 2 is a schematic, isometric view of the heat pipe assembly from a visual angle different from FIG. 1.

FIG. 3 is a partially, cross-sectional view of FIG. 1.

FIG. 4 is a partially, cross-sectional view of FIG. 2.

FIG. 5 is a partially, cross-sectional view of a heat pipe assembly, according to a second embodiment of the present disclosure.

FIG. 6 is a partially, exploded view of a heat dissipation device of the present disclosure.

### DETAILED DESCRIPTION

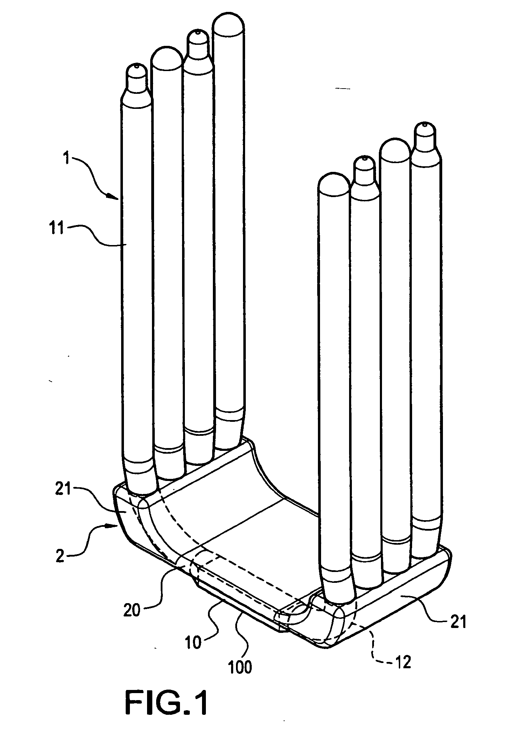

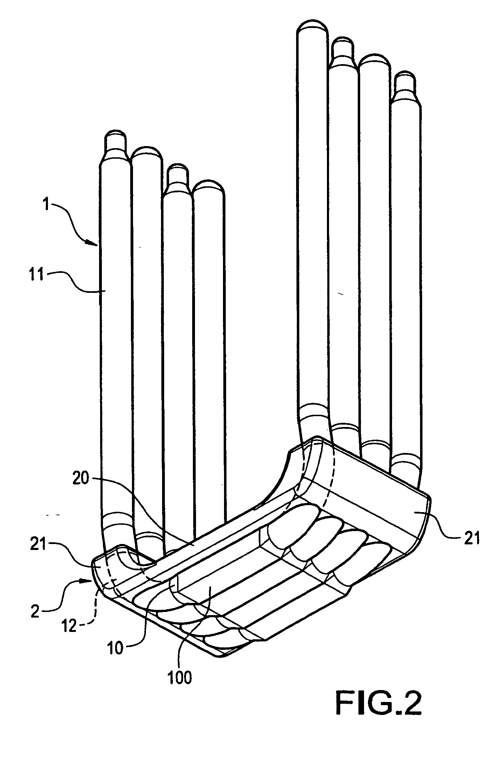

FIGS. 1 and 2 are schematic, isometric views of a heat pipe assembly of the present invention in different visual angles. The heat pipe assembly includes a number of heat pipes 1 and a fixing seat 2.

Each of the heat pipes 1 is heat conducting element and includes a vacuous tubular body, a capillary structure disposed inside the tubular body and a working fluid contained in the tubular body and soaking the capillary structure. The tubular body of each of the heat pipes 1 is an integral structure and has a certain length. The heat pipes 1 each include an evaporating section 10 and at least a condensing section 11 connected with the evaporating section 10. In the present embodiment, each of the heat pipes 1 has a U-shaped configuration, a bottom portion of the U-shaped configuration is the evaporating section 10, and two lateral portions of the U-shaped configuration are two condensing sections 11. A curved section 12 is connected between the evaporation section 10 and each condensing section 11. Thus, the evaporation section 10, two condensing sections 11 and two curved sections 12 cooperatively form each of the heat pipes 1. In addition, the cross-section of the evaporation section 10 of each of the heat pipes 1 is rectangular, so that each of the heat pipes has a flat heat absorbing surface 100. Evaporating sections 10 of the heat pipes 1 are parallel to and adjoin with each other, whereby the heat absorb surfaces 100 of the evaporating sections 10 are coplanar and adjoin with each other to thereby form a large-area heat absorbing surface.

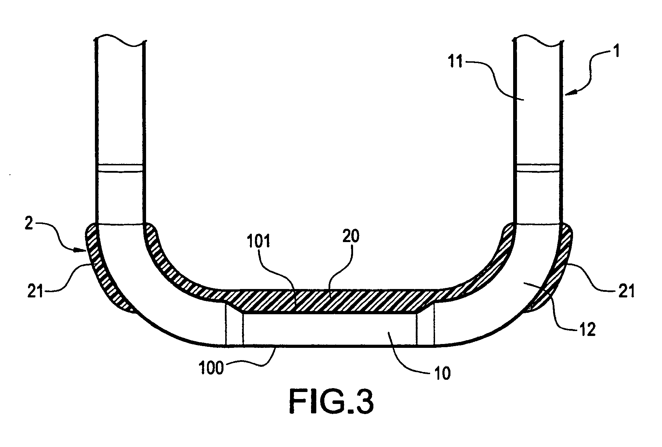

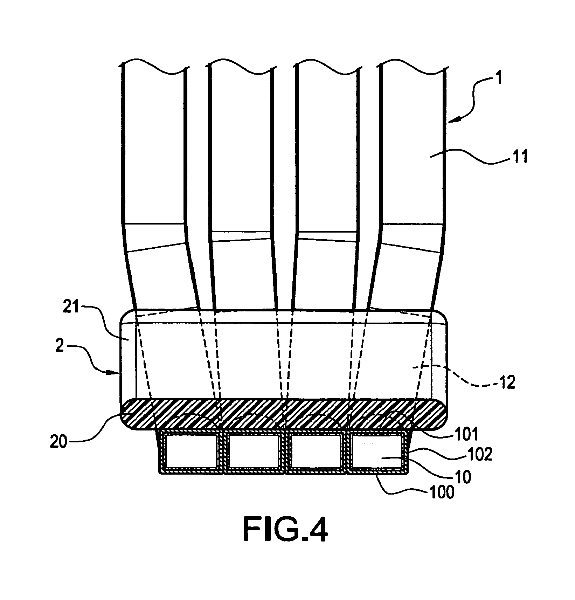

The fixing seat 2 has an integral configuration and is made of plastic materials, such as, PC, PP, PE, PU or the like. The fixing seat 2 is made by integral molding process, e.g., injection molding, gel-casting molding, perfusion molding, die casting, dipping and so on. The fixing seat 2 engages with the evaporating sections 10 of the heat pipes 1. Referring to FIGS. 3 and 4, the fixing seat 3 has a base 20, a top surface the evaporation section 10 of each of the heat pipes 1 has a top edge 101. The base 20 has a bottom surface combining with the top edge 101 of the top surface of the evaporation section 10 of each of the heat pipes 1, whereby the evaporation sections 10 of the heat pipes 1 can be secured to enable the heat absorbing surfaces 100 of the evaporation sections 10 of the heat pipes 1 being parallel to and adjoining with each other. As a result, the heat absorbing surfaces 100 are coplanar and adjoin with each other to form a large-area surface, thereby facilitating thermally contacting with heat-generating sources (not shown). In addition, in order to increase a contact area between the fixing seat 2 and the heat pipes 1, the fixing seat 2 further includes two reinforcement portions 21 respectively extending outwardly from two lateral ends of the base 20. The reinforcement portion 21 located at right side of the base 20 of the fixing seat 2 encloses all of the curved sections 12 of the heat pipes 1 located at right side of the base 20 of the fixing seat 2; the reinforcement portion 21 located at left side of the base 20 of the fixing seat 2 encloses all of the curved sections 12 of the heat pipes 1 located at left side of the base 20 of the fixing seat 2; thereby enhancing a bonding strength between the fixing seat 2 and the heat pipes 1.

In order to ensure the evaporation sections 10 of the heat pipes 1 being parallel to and adjoining with each other, the cross section of each of the evaporation sections 10 is square or rectangular, as shown in FIG. 4. Thus, each of the evaporation sections 10 has two vertical lateral walls 102, and the lateral walls 102 of adjacent evaporation sections 10 tightly joint with each other. As a result, the evaporation sections 10 of the heat pipes 1 can be gathered together to facilitate the evaporation sections 10 of the heat pipes 1 exchanging heat, whereby the heat pipes 1 can be evenly heated. Furthermore, as shown in FIG. 4, the curved sections 12 of the heat pipes 1 are radially arranged relative to an assembly of the evaporation sections 10 of the heat pipes, that is, adjacent curved sections 12 are angled with each other, whereby the condensing sections 11 of the heat pipes 1 are spaced from each other. In the illustrated embodiment, the condensing sections 11 of the heat pipes 1 are vertical to the evaporating sections 10 of the heat pipes 1.

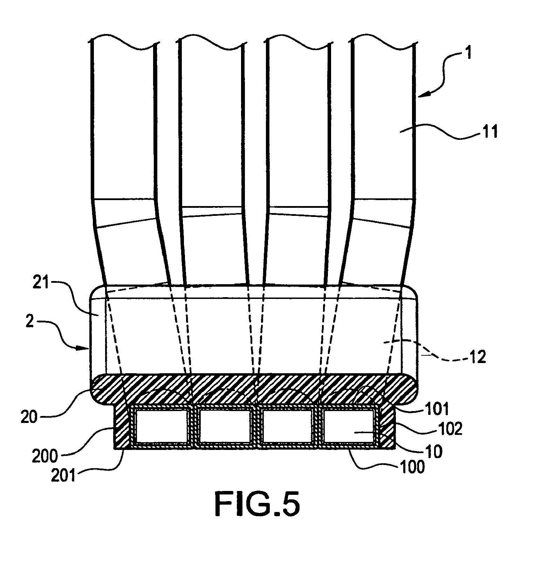

Referring to FIG. 5, the fixing seat 2 includes two enclosing portions 200 extending downwardly from the base 20 to respectively enclose the lateral walls 102 of the two outermost heat pipes 1, thereby enhancing the bonding strength among the evaporating sections 10 of the heat pipes 1. The enclosing portions 200 each include a bottom edge 201 not protrude downwardly relative to the heat absorbing surfaces 100. In the present embodiment, the bottom edges 201 of the enclosing portions 200 are coplanar with the heat absorbing surfaces 100.

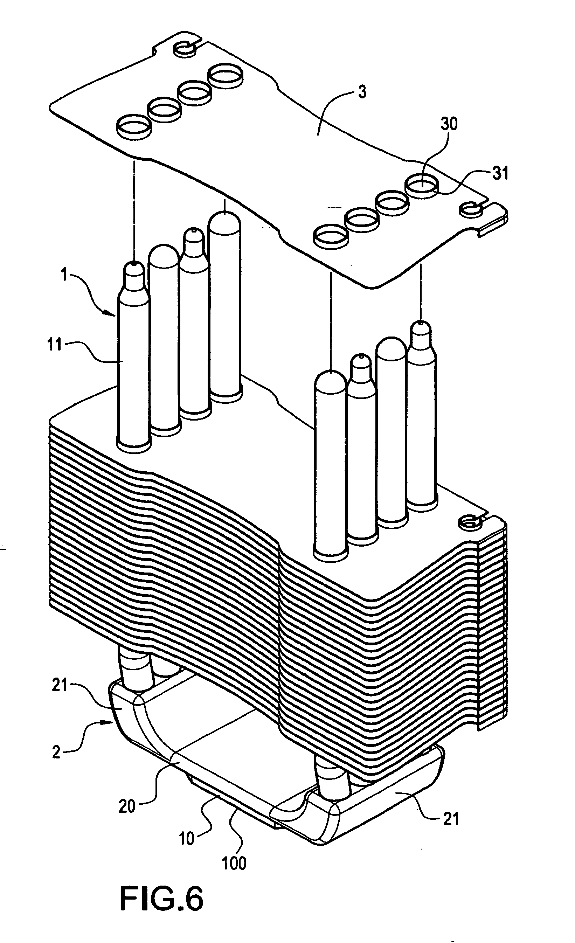

Referring to FIG. 6, a heat sink having the above-described heat pipe assembly of FIG. 1 is illustrated. The heat sink includes a number of heat conducting fins 3. The heat conducting fins 3 are parallel to and equidistantly spaced from each other. Two lateral portions of each of the heat conducting fins 3 defines a number of through holes 30 to allow the condensing sections 11 of the heat pipes 1 passing therethrough. An annular protruded flange 31 extends upwardly from an circumference edge defining each of the through holes 30 to enable adjacent heat conducting fins 3 spaces a certain distance. Thus, the heat conducting fins 3 define a number of airflow passages to increase heat dissipation efficiency. In assembly, the condensing sections 11 of the heat pipes 1 respectively extend the through holes 30 of the heat conducting fins 3 to enable an assembly of the heat conducting fins 3 locating over the evaporation sections 10 of the heat pipes 1.

Therefore, the heat pipes 1 and the fixing seat 2 cooperatively constitute the heat pipe assembly; the heat pipe assembly and the heat conducting fins 3 are construct the heat sink.

## Claims

1. A heat pipe assembly, comprising:
- a plurality of heat pipes (1), each having an evaporating section (10) and a condensing section (11), a bottom of the evaporating section (10) of each of the heat pipes (1) being flat and having a flat heat absorbing surface (100), evaporating sections (10) of the heat pipes (1) being parallel to each other, whereby the flat heat absorbing surfaces (100) of the evaporating sections (10) of the heat pipes (1) being coplanar and adjoining with each other, a top surface of the evaporating section (10) of each of the heat pipes (1) having a top edge (101); and
- a fixing seat (2) having an integral structure and combing with the top edge (101) of the evaporating section (10) of each of the heat pipes (1), whereby the heat absorbing surfaces (100) of the evaporating sections (10) of the heat pipes (1) are coplanar;
**characterized in that** the heat absorbing surfaces (100) of the evaporating sections (10) of the heat pipes (1) adjoin with each other, and the evaporating section (10) of each of the heat pipes (1) has a rectangular cross-section.

2. The heat pipe assembly as claimed in claim 1, wherein each of the heat pipes (1) further comprises a curved section (12) connected between the evaporating section (10) and the condensing section (11) thereof.

3. The heat pipe assembly as claimed in claim 2, wherein the curved sections (12) of the heat pipes (1) are radially arranged and angled with each other, whereby the condensing sections (11) of the heat pipes are spaced from each other.

4. The heat pipe assembly as claimed in claim 2, wherein the fixing seat (2) further comprises a reinforcement portion (21) enclosing the curved section (12) of each of the heat pipes (1).

5. The heat pipe assembly as claimed in claim 1, wherein the evaporating section (10) of each of the heat pipes (1) has two vertical lateral walls (102) to enable the vertical lateral walls (102) of the heat pipes (1) tightly joint with each other.

6. The heat pipe assembly as claimed in claim 5, wherein the fixing seat (2) further comprises an enclosing portion (200) enclosing the lateral walls of the two outermost heat pipes (1).

7. The heat pipe assembly as claimed in claim 6, wherein the enclosing portion (200) of the fixing seat (2) has a bottom edge (201) coplanar with the heat absorbing surfaces (100) of the evaporating sections (10) of the heat pipes (1).

## Patentansprüche

1. Wärmerohranordnung, die umfasst:
- mehrere Wärmerohre (1), wovon jedes einen Verdampfungsabschnitt (10) und einen Kondensationsabschnitt (11) besitzt, wobei ein Boden des Verdampfungsabschnitts (10) jedes der Wärmerohre (1) eben ist und eine ebene Wärmeabsorptionsoberfläche (100) besitzt, wobei Verdampfungsabschnitte (10) der Wärmerohre (1) zueinander parallel sind, wobei die ebenen Wärmeabsorptionsoberflächen (100) der Verdampfungsabschnitte (10) der Wärmerohre (1) koplanar sind und aneinander grenzen, wobei eine obere Oberfläche des Verdampfungsabschnitts (10) jedes der Wärmerohre (1) eine Oberkante (101) besitzt; und
- einen Befestigungssitz (2), der eine einteilige Struktur besitzt und mit der Oberkante (101) des Verdampfungsabschnitts (10) jedes der Wärmerohre (1) verbunden ist, wobei die Wärmeabsorptionsoberflächen der Verdampfungsabschnitte (10) der Wärmerohre (1) koplanar sind;
**dadurch gekennzeichnet, dass** die Wärmeabsorptionsoberflächen (100) der Verdampfungsabschnitte (10) der Wärmerohre (1) aneinander grenzen und der Verdampfungsabschnitt (10) jedes der Wärmerohre (1) einen rechtwinkligen Querschnitt besitzt.

2. Wärmerohranordnung nach Anspruch 1, wobei jedes der Wärmerohre (1) ferner einen gekrümmten Abschnitt (12) umfasst, wird zwischen dem Verdampfungsabschnitt (10) und dem Kondensationsabschnitt (11) angeschlossen ist.

3. Wärmerohranordnung nach Anspruch 2, wobei die gekrümmten Abschnitte (12) der Wärmerohre (1) radial angeordnet und zueinander angewinkelt sind, wobei die Kondensationsabschnitte (11) der Wärmerohre voneinander beabstandet sind.

4. Wärmerohranordnung nach Anspruch 2, wobei der Befestigungssitz (2) ferner einen Verstärkungsabschnitt (21) umfasst, der den gekrümmten Abschnitt (12) jedes der Wärmerohre (1) umschließt.

5. Wärmerohranordnung noch Anspruch 1, wobei der Verdampfungsabschnitt (10) jedes der Wärmerohre (1) zwei vertikale Seitenwände (102) besitzt, um den vertikalen Seitenwänden (102) der Wärmerohre (1) zu ermöglichen, dicht miteinander verbunden zu sein.

6. Schraubenrohranordnung nach Anspruch 5, wobei der Befestigungssitz (2) ferner einen Umschließungsabschnitt (200) umfasst, der die Seitenwände der zwei äußersten Wärmerohre (1) umschließt.

7. Wärmerohranordnung nach Anspruch 6, wobei der Umschließungsabschnitt (200) des Befestigungssitzes (2) eine Bodenkante (201) besitzt, die zu den Wärmeabsorptionsoberflächen (100) der Verdampfungsabschnitte (10) der Wärmerohre (1) koplanar ist.

## Revendications

1. Ensemble à tubes caloducs, comprenant :
- une pluralité de tubes caloducs (1), chacun ayant une section d'évaporation (10) et une section de condensation (11), un fond de la section d'évaporation (10) de chacun des tubes caloducs (1) étant plat et ayant une surface d'absorption de chaleur plane (100), les sections d'évaporation (10) des tubes caloducs (1) étant parallèles les unes aux autres, dans lequel les surfaces d'absorption de chaleur planes (100) des sections d'évaporation (10) les tubes caloducs (1) sont coplanaires et jointives les unes aux autres, une surface de sommet de la section d'évaporation (10) de chacun des tubes caloducs (1) ayant un bord supérieur (101) ; et
- un siège de fixation (2) ayant une structure intégrale et combinée avec la bordure supérieure (101) de la section d'évaporation (10) de chacun des tubes caloducs (1), dans lequel les surfaces d'absorption de chaleur (100) des sections d'évaporation (10) des tubes caloducs (1) sont coplanaires ;
**caractérisé en ce que** les surfaces d'absorption de chaleur (100) des sections d'évaporation (10) des tubes caloducs (1) sont jointives les unes aux autres, et la section d'évaporation (10) de chacun des tubes caloducs (1) a une section transversale rectangulaire.

2. Ensemble à tubes caloducs selon la revendication 1, dans lequel chacun des tubes caloducs (1) comprend en outre une section incurvée (12) connectée entre la section d'évaporation (10) et la section de condensation (11) de lui-même.

3. Ensemble à tubes caloducs selon la revendication 2, dans lequel les sections incurvées (12) des tubes caloducs (1) sont agencées radialement et sous un angle les unes par rapport aux autres, et dans lequel les sections de condensation (11) des tubes caloduc sont espacées les unes des autres.

4. Ensemble à tubes caloducs selon la revendication 2, dans lequel le siège de fixation (2) comprend en outre une portion de renforcement (21) qui enferme la section incurvée (12) de chacun des tubes caloducs (1).

5. Ensemble à tubes caloducs selon la revendication 1, dans lequel la section d'évaporation (10) de chacun des tubes caloducs (1) a deux parois latérales verticales (102) pour permettre aux parois latérales verticales (102) des tubes caloducs (1) d'être intimement jointives les unes aux autres.

6. Ensemble à tubes caloducs selon la revendication 5, dans lequel le siège de fixation (2) comprend en outre une portion formant enceinte (200) qui enferme les parois latérales des deux tubes caloducs (1) les plus extérieures.

7. Ensemble à tubes caloducs selon la revendication 6, dans lequel la portion formant enceinte (200) du siège de fixation (2) a une bordure inférieure (201) coplanaire avec les surfaces d'absorption de chaleur (100) des sections d'évaporation (10) des tubes caloducs (1).
